# EUROPEAN PATENT APPLICATION

(11) **EP 4 848 287 A1**
(43) Date of publication of application: **02.12.2026**
(21) Application number: 24926744.4
(22) Date of filing: 29.09.2024
(51) Int. Cl.: G11C 11/408

(54) **WORD LINE DRIVER, MEMORY, AND DEVICE**

(30) Priority: 26.02.2024 CN 202410211864
(71) Applicant: Huawei Technologies Co., Ltd., Shenzhen, Guangdong 518129 (CN)
(72) Inventor: YIN, Shihui, Shenzhen, Guangdong 518129 (CN); ZHANG, Wenqiang, Shenzhen, Guangdong 518129 (CN); JING, Weiliang, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Goddar, Heinz J.
(86) International application number: PCT/CN2024/122481
(87) International publication number: WO 2025/179877

(57) **Abstract**

A word line driver, a memory, and a device are provided, and relate to the field of electronic technologies, to reduce a size of an SWD and reduce load of word line driving. The word line driver includes a first word line, a first sub-word line, and a second sub-word line. The first SWD includes a first transistor and a second transistor, the second SWD includes a third transistor and a fourth transistor, and the two SWDs share a fifth transistor. Gates of the first transistor, the third transistor, and the fifth transistor are all coupled to the first word line. Electrodes of the first transistor, the second transistor, and the fifth transistor are all coupled to the first sub-word line. Electrodes of the third transistor and the fourth transistor, and another electrode of the fifth transistor are all coupled to the second sub-word line. Other electrodes of the first transistor and the third transistor are configured to receive two selection signals. Other electrodes of the second transistor and the fourth transistor are both coupled to a ground end. Gates of the second transistor and the fourth transistor are configured to receive inverted signals of the two selection signals.

## Description

This application claims priority to Chinese Patent Application No. 202410211864.1, filed with the China National Intellectual Property Administration on February 26, 2024 and entitled "WORD LINE DRIVER, MEMORY, AND DEVICE", which is incorporated herein by reference in its entirety.

### TECHNICAL FIELD

This application relates to the field of electronic technologies, and in particular, to a word line driver, a memory, and a device.

### BACKGROUND

Dynamic random access memory (dynamic random access memory, DRAM), as a main memory, has been widely used in various electronic devices such as mobile phones, computers, servers, and automotive electronic systems. A memory cell in DRAM is usually of a 1T1C structure, that is, the memory cell includes one transistor and one capacitor.

Currently, requirements for capacity density of the DRAM are increasingly high. Therefore, DRAM manufacturers continuously develop technologies to reduce the area of each memory cell to achieve higher storage density. However, in addition to the need to reduce the area of the memory cell, sizes of corresponding peripheral circuits such as a sub-word line driver (sub-word line driver, SWD) and a sense amplifier (sense amplifier, SA) also need to be synchronously reduced, so as to ensure improvement of overall storage density.

### SUMMARY

This application provides a word line driver, a memory, and a device, to reduce a size of a sub-word line driver, increase storage density of the memory, and reduce load of word line driving.

To achieve the foregoing objectives, the following technical solutions are used in embodiments of this application.

According to a first aspect, a word line driver is provided. The word line driver includes a plurality of word lines (also referred to as main word lines) that may be configured to provide a plurality of primary selection signals, where the plurality of word lines include a first word line, and the first word line provides a first primary selection signal; a plurality of sub-word lines, including a first sub-word line and a second sub-word line that are sub-word lines coupled to two sub-word line drivers in a same group; and a plurality of sub-word line drivers, including a first sub-word line driver and a second sub-word line driver that are two sub-word line drivers in a same group. The first sub-word line driver includes a first transistor and a second transistor, the second sub-word line driver includes a third transistor and a fourth transistor, and the first sub-word line driver and the second sub-word line driver further share a fifth transistor. A gate of the first transistor, a gate of the third transistor, and a gate of the fifth transistor are all coupled to the first word line (that is, all configured to receive the first primary selection signal). An electrode of the first transistor, an electrode of the second transistor, and an electrode of the fifth transistor are all coupled to the first sub-word line. An electrode of the third transistor, an electrode of the fourth transistor, and another electrode of the fifth transistor are all coupled to the second sub-word line. Another electrode of the first transistor and another electrode of the third transistor are respectively configured to receive a first selection signal and a second selection signal. Another electrode of the second transistor and another electrode of the fourth transistor are both coupled to a ground end. A gate of the second transistor and a gate of the fourth transistor are respectively configured to receive an inverted signal of the first selection signal and an inverted signal of the second selection signal.

In the foregoing technical solution, the first sub-word line driver and the second sub-word line driver each include two independent transistors, and the two sub-word line drivers further share the transistor. In this way, each sub-word line driver requires only 2.5 transistors on average. In comparison with a conventional sub-word line driver that needs three transistors, an area of the sub-word line driver can be reduced, and overall storage density of a memory can be improved. In addition, the gate of the first transistor, the gate of the third transistor, and the gate of the fifth transistor that are in the two sub-word line drivers are all coupled to the same word line. In this way, a word line coupled to each sub-word line driver is required to drive only 1.5 transistors on average. In comparison with the conventional sub-word line driver in which one word line is coupled to two transistors and therefore needs to drive two transistors, load of word line driving can be reduced, thereby reducing power consumption of a circuit that provides a word line signal.

In a possible implementation of the first aspect, the word line driver further includes a plurality of selection lines that provide the selection signals and the inverted signals, the plurality of word lines and the plurality of selection lines are disposed in a routing layer on a side of a substrate, the plurality of word lines extend in a first direction parallel to the substrate, the plurality of selection lines extend in a second direction parallel to the substrate, and the first direction is perpendicular to the second direction. In the foregoing possible implementation, by setting the plurality of word lines to extend in the first direction, and the plurality of selection lines to extend in the second direction, where the first direction is perpendicular to the second direction, this can facilitate coupling of the plurality of word lines and the plurality of selection lines to the corresponding sub-word line driver, routing difficulty of the plurality of word lines and the plurality of selection lines is reduced, and coupling reliability is improved.

In a possible implementation of the first aspect, the first transistor and the third transistor are PMOS transistors, and the second transistor, the fourth transistor, and the fifth transistor are NMOS transistors. In the foregoing possible implementation, the first sub-word line driver and the second sub-word line driver share the fifth transistor that is the NMOS transistor, so that the area of the sub-word line driver can be reduced, and the overall storage density of the memory can be improved.

In a possible implementation of the first aspect, the word line driver further includes a PMOS region and an NMOS region that are separately disposed, a plurality of PMOS transistors in the plurality of sub-word line drivers are disposed in the PMOS region, and a plurality of NMOS transistors in the plurality of sub-word line drivers are disposed in the NMOS region. In the foregoing possible implementation, by separately disposing the PMOS region used to dispose the plurality of PMOS transistors and the NMOS region used to dispose the plurality of NMOS transistors, integration of the plurality of PMOS transistors and the plurality of NMOS transistors in the word line driver can be improved.

In a possible implementation of the first aspect, the PMOS region and the NMOS region include a gate layer, and at least a part of the plurality of word lines are discontinuous in the gate layer. Optionally, each of the at least a part of word lines includes a first word line segment and a second word line segment that are located at the gate layer, and the first word line segment is connected to the second word line segment through at least one routing layer. In the foregoing possible implementation, integration of a plurality of transistors in the word line driver can be improved, and the at least a part of word lines are connected to gates of corresponding transistors in the PMOS region and the NMOS region in the discontinuous manner at the gate layer.

In a possible implementation of the first aspect, the NMOS region includes a first NMOS region and a second NMOS region that are disposed on two sides of the PMOS region, one part of the plurality of NMOS transistors is located in the first NMOS region, and the other part of the plurality of NMOS transistors is located in the second NMOS region. In the foregoing possible implementation, the first NMOS region and the second NMOS region are disposed on the two sides of the PMOS region, so that the PMOS region and the NMOS region can be separately disposed, and flexibility of disposing the NMOS region can be further improved.

In a possible implementation of the first aspect, the PMOS region and the NMOS region include a gate layer, and each of the plurality of word lines is continuous in the gate layer. In the foregoing possible implementation, integration of a plurality of transistors in the word line driver can be improved, and complexity of coupling between the plurality of word lines and gates of corresponding transistors can be reduced.

According to a second aspect, a memory is provided, where the memory includes a memory array tile and a peripheral circuit coupled to the memory array tile, and the peripheral circuit includes the word line driver according to any one of the first aspect or the possible implementations of the first aspect.

In a possible implementation of the second aspect, the memory includes one of the following: a dynamic random access memory DRAM, a static random access memory SRAM, a magnetic random access memory MRAM, a resistive random access memory ReRAM, a ferroelectric random access memory FeRAM, or a phase change memory PCM.

According to a third aspect, a storage device is provided. The storage device includes a controller and the memory according to any one of the second aspect or the possible implementations of the second aspect, and the controller is configured to control reading and writing of the memory.

According to a fourth aspect, an electronic device is provided. The electronic device includes a processor and a memory that are coupled to each other, and the memory is the memory according to any one of the second aspect or the possible implementations of the second aspect.

It may be understood that, for beneficial effect that can be achieved by any memory, storage device, and electronic device provided above, refer to the beneficial effect in the word line driver provided above. Details are not described herein again.

### BRIEF DESCRIPTION OF DRAWINGS

FIG. 1 is a diagram of a structure of a sub-word line driver;
FIG. 2 is a diagram of a structure of another sub-word line driver;
FIG. 3 is a diagram of a structure of a memory according to an embodiment of this application;
FIG. 4 is a diagram of a structure of a word line driver according to an embodiment of this application;
FIG. 5 is a diagram of a structure of another word line driver according to an embodiment of this application;
FIG. 6 is a layout of a word line driver according to an embodiment of this application;
FIG. 7 is a layout of another word line driver according to an embodiment of this application;
FIG. 8 is a diagram of a structure of a storage device according to an embodiment of this application; and
FIG. 9 is a diagram of a structure of an electronic device according to an embodiment of this application.

### DESCRIPTION OF EMBODIMENTS

The following describes the technical solutions in embodiments of this application with reference to the accompanying drawings in embodiments of this application. In this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof means any combination of these items, including any combination of singular items (pieces) or plural items (pieces). For example, at least one (piece) of a, b, or c may indicate: a, b, c, a and b, a and c, b and c, or a, b, and c, where a, b, and c may be singular or plural.

In embodiments of this application, words such as "first" and "second" are used to distinguish between objects with similar names or functions or effect. A person skilled in the art may understand that the words such as "first" and "second" do not limit a quantity and an execution sequence. The term "coupling" is used for representing an electrical connection, including a direct connection through a wire or a connection end or an indirect connection through another device. Therefore, "coupling" should be considered as a generalized electronic communication connection.

In this application, a word such as "example" or "for example" is used to represent giving an example, an illustration, or a description. Any embodiment or design scheme described as an "example" or "for example" in this application should not be explained as being more preferred or having more advantages than another embodiment or design scheme. Exactly, use of the words such as "example" or "for example" is intended to present a relative concept in a specific manner.

Before embodiments of this application are described, related technologies and scenarios in embodiments of this application are first described.

To improve storage density of a memory, circuits in a peripheral circuit of the memory usually need to be miniaturized, so as to reduce a size of the peripheral circuit thereby reduce a size of the memory. As an important component in the peripheral circuit, sub-word line drivers (sub-word line drivers, SWDs) are large in quantity and size. Therefore, the size of the peripheral circuit can be reduced by reducing the sizes of the sub-word line drivers.

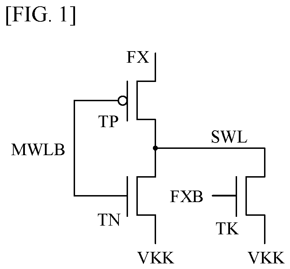

FIG. 1 is a diagram of a structure of a sub-word line driver SWD according to this application. The sub-word line driver SWD has a conventional structure, and includes three transistors that are represented as TP, TN, and TK. A gate of the transistor TP and a gate of the transistor TN are jointly connected to an inverted signal MWLB of a main word line (main word line). A source of the transistor TP is connected to a sub-word line selection signal FX. Sources of the transistor TN and the transistor TK are connected to a low-level power supply terminal VKK. A gate of the transistor TK is connected to an inverted signal FXB of the sub-word line selection signal. A drain of the transistor TP, a drain of the transistor TN, and a drain of the transistor TK are connected to serve as an output node of the sub-word line driver SWD, and are configured to couple to a sub-word line SWL (sub-word line). The inverted signal may also be referred to as a complement signal.

The transistor TP is a P-type field effect transistor, and the transistor TN and the transistor TK are N-type field effect transistors. Specifically, when MWLB is at a low level, FX is at a high level, and FXB is at a low level, the SWL is driven to be at a high level, the transistor TP is in an on state, and the sub-word line driver SWD is selected. When MWLB is at a high level, or FX is at a low level and FXB is at a high level, the SWL is driven to be at a low level, the transistor TP is in an off state, the transistor TN is in the on state, and the sub-word line driver SWD is selected. In this way, logically, the sub-word line driver SWD implements logic and operations of MWLB and FX, and completes last-level coding of the sub-word line SWL.

In the conventional structure of the sub-word line driver SWD provided in FIG. 1, each SWD needs three transistors. In this way, storage density of a memory is reduced when the SWD is used in a peripheral circuit and the memory.

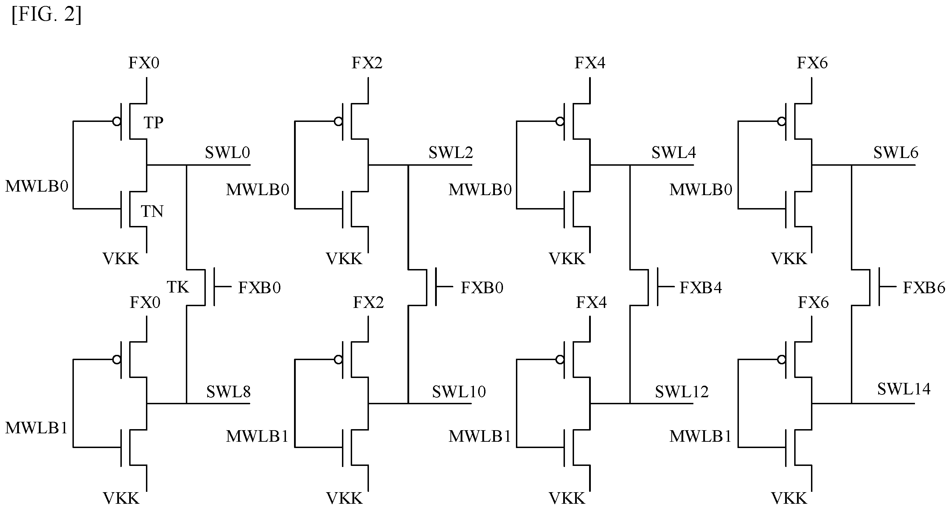

Further, with reference to FIG. 1, FIG. 2 is a diagram of a structure of a plurality of sub-word line drivers SWD according to this application. Two sub-word line drivers SWD that are in the plurality of sub-word line drivers SWD and that are controlled by two adjacent pieces of MWLB form one group. Each sub-word line driver SWD includes the transistor TP and the transistor TN, and the two sub-word line drivers SWD further share the same transistor TK. In FIG. 2, 10 groups of SWDs are used as an example for description, and corresponding MWLB, FX, FXB, and SWL are represented as MWLB0 to MWLB1, FX0 to FX2m, FXB0 to FXB2m, and SWL0 to SWL2n. A value range of m is from 1 to 3, and a value range of n is from 1 to 7.

Specifically, when a sub-word line driver SWD is selected, coupled MWLB corresponding to the sub-word line driver SWD is at a low level, FX is at a high level, FXB is at a low level, and the sub-word line SWL is pulled up to a high level via the transistor TP. When a sub-word line driver SWD is not selected, there may be two cases. In a first case, MWLB is at a high level, and the sub-word line SWL is pulled down to a low level via the transistor TN. In a second case, MWLB is at a low level, FX is at a low level, FXB is at a high level, and the sub-word line SWL is pulled down to a low level via the shared transistor TK and the transistor TN of the other sub-word line driver SWD in a same group (where MWLB of the other sub-word line driver SWD is at a high level, because at most one piece of MWLB in adjacent MWLB is at a low level).

In the structure of the sub-word line drivers SWD provided in FIG. 2, logical functions of two sub-word line drivers SWD are implemented via five transistors based on a feature that at most one piece of MWLB in MWLB of the sub-word line drivers SWD in the same group is at a low level. However, this solution makes routing difficult during actual layout implementation. Because the two sub-word line drivers SWD belonging to the same group are sub-word line drivers SWD coupled to different MWLB, a numbering interval of sub-word lines SWL of the two sub-word line drivers SWD is large, and adjustment needs to be made during layout implementation.

In view of this, embodiments of this application provide a word line driver having a plurality of sub-word line drivers SWD. In the word line driver, each sub-word line driver SWD requires only 2.5 transistors on average, so that an area of the sub-word line driver SWD can be reduced. In addition, in a first sub-word line driver and a second sub-word line driver that share a same transistor in the word line driver, three transistors are all coupled to a same word line, and routing is easy. In addition, a word line coupled to each sub-word line driver SWD is required to drive only 1.5 transistors on average. In comparison with a conventional sub-word line driver SWD in which one word line is coupled to two transistors and therefore needs to drive two transistors, load of word line driving can be reduced, thereby reducing power consumption of a circuit that provides a word line signal.

The word line driver provided in embodiments of this application may be used in a plurality of memories. The memory may include but is not limited to a dynamic random access memory (dynamic random access memory, DRAM), a static random access memory (static random access memory, SRAM), a magnetic random access memory (magnetic random access memory, MRAM), a resistive random access memory (resistive random access memory, ReRAM), a ferroelectric random access memory (ferroelectric random access memory, FeRAM), a phase change memory (phase change memory, PCM), or the like. Optionally, the DRAM may include a synchronous dynamic random access memory (synchronous dynamic random access memory, SDRAM), a double data rate synchronous dynamic random access memory (double data rate synchronous dynamic random access memory, DDR SDRAM), a rambus dynamic random access memory (rambus dynamic random access memory, RDRAM), and the like. The DDR SRAM may also be referred to as a DDR for short. These are not enumerated one by one in embodiments of this application for description.

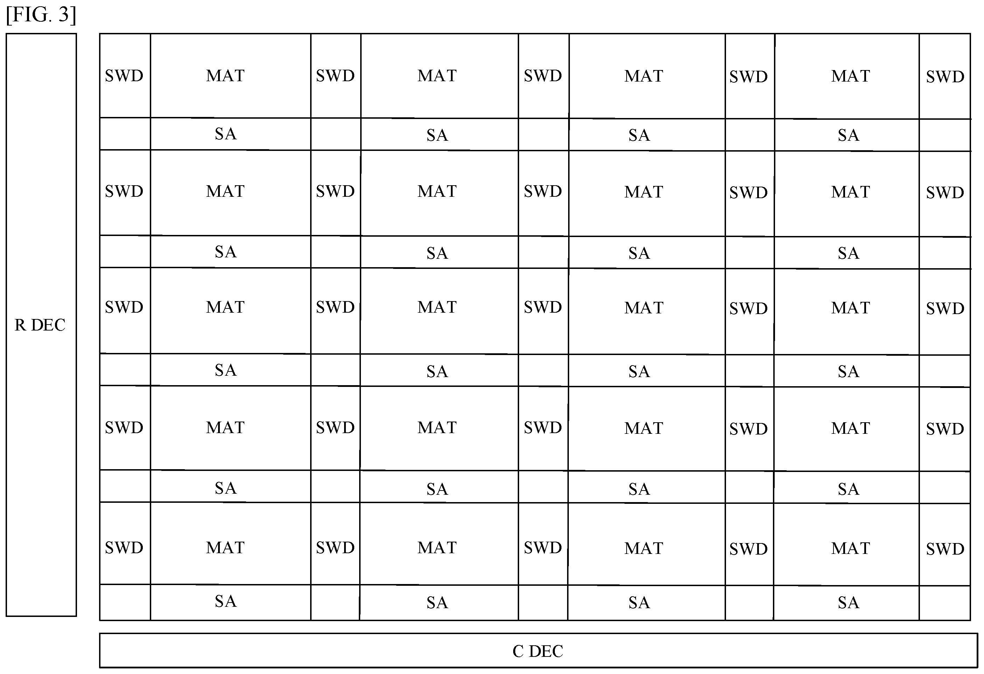

For example, FIG. 3 is a diagram of a structure of a memory according to an embodiment of this application. The memory includes a plurality of memory array tiles MAT and a peripheral circuit coupled to the plurality of memory array tiles MAT. The peripheral circuit may include: a row decoder (row decoder, R DEC), a column decoder (column decoder, C DEC), a word line driver, a plurality of sense amplifiers (sense amplifier, SA), and the like. The word line driver may include a plurality of sub-word line drivers SWD, and the plurality of sub-word line drivers SWD and the plurality of sense amplifiers SA are separately coupled to the plurality of memory array tiles MAT. FIG. 3 is described by using an example in which all of the plurality of memory array tiles MAT are coupled to different sense amplifiers SA, and two adjacent memory array tiles MAT share the sub-word line driver SWD.

In the memory, the row decoder R DEC may be configured to perform row address decoding on data in a read/write operation corresponding to the plurality of memory array tiles MAT, the column decoder (column decoder, C DEC) may be configured to perform column address decoding on the data in the read/write operation corresponding to the plurality of memory array tiles MAT, the sub-word line driver SWD coupled to each memory array tile MAT may be configured to control gating or disabling of a memory cell in the memory array tile MAT, and the sense amplifier SA coupled to each memory array tile MAT may be configured to amplify data read from the memory array tile MAT or drive data to be written into the memory array tile MAT.

Further, the word line driver may further include a plurality of word lines (also referred to as a plurality of main word lines) and a plurality of sub-word lines. Each sub-word line driver SWD may be coupled to one word line and one sub-word line, and different word lines may be coupled to different sub-word lines. For example, each word line may be coupled to eight sub-word lines in each memory array tile. The plurality of word lines and the plurality of sub-word lines are not shown in FIG. 3.

It may be understood that the structure of the memory provided in FIG. 3 does not constitute a limitation on the memory. In actual application, the memory may further include more or fewer components than those shown in the figure, or combine some components, or have different component arrangements.

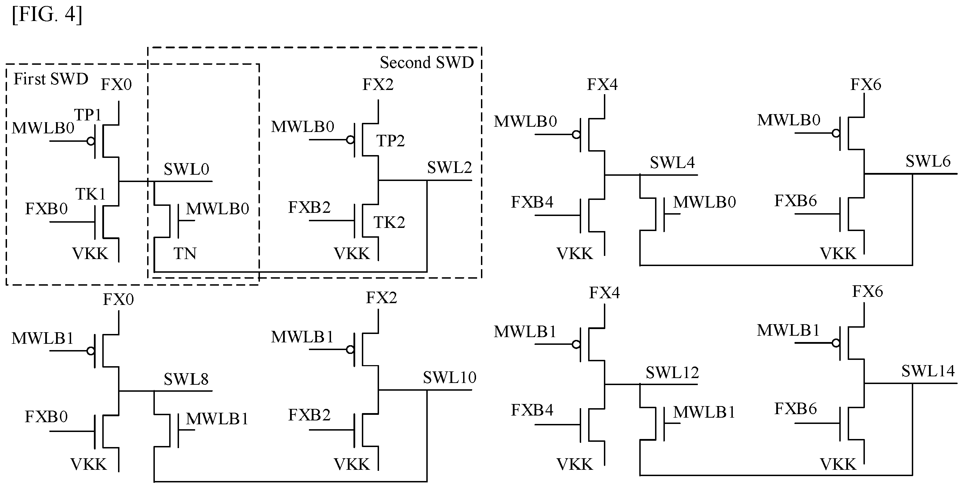

FIG. 4 is a diagram of a structure of a word line driver according to an embodiment of this application. The word line driver includes a plurality of word lines, a plurality of sub-word lines, and a plurality of SWDs. The plurality of SWDs may include a plurality of groups, each group includes two SWDs, and two SWDs in a same group may be coupled to one word line and two sub-word lines. The following uses a group of SWDs in the word line driver as an example to describe a structure of the word line driver.

In a possible embodiment, the plurality of word lines include a first word line, the plurality of sub-word lines include a first sub-word line and a second sub-word line, and the plurality of SWDs include a first SWD and a second SWD. The first SWD includes a first transistor and a second transistor, the second SWD includes a third transistor and a fourth transistor, and the first SWD and the second SWD further share a fifth transistor. A gate of the first transistor, a gate of the third transistor, and a gate of the fifth transistor are all coupled to the first word line. An electrode of the first transistor, an electrode of the second transistor, and an electrode of the fifth transistor are all coupled to the first sub-word line. An electrode of the third transistor, an electrode of the fourth transistor, and another electrode of the fifth transistor are all coupled to the second sub-word line. Another electrode of the first transistor and another electrode of the third transistor are respectively configured to receive a first selection signal and a second selection signal. Another electrode of the second transistor and another electrode of the fourth transistor are both coupled to a ground end VKK. A gate of the second transistor and a gate of the fourth transistor are respectively configured to receive an inverted signal of the first selection signal and an inverted signal of the second selection signal. The first selection signal and the second selection signal, and the inverted signal of the first selection signal and the inverted signal of the second selection signal are provided by a plurality of selection lines.

The first word line may be any one of the plurality of word lines, the word lines may be configured to provide different primary selection signals MWLB, and the word lines may be coupled to different groups of SWDs in the plurality of groups of SWDs. For example, in FIG. 4, an example in which the plurality of word lines include two word lines, primary selection signals MWLB provided by the two word lines are MWLB0 and MWLB1, MWLB0 is coupled to four groups of SWDs, and MWLB1 is coupled to four other groups of SWDs is used for description. The first sub-word line and the second sub-word line are sub-word lines SWL coupled to two SWDs in a same group, and sub-word lines SWL coupled to SWDs in different groups are different. For example, in FIG. 4, an example in which the word line driver includes eight groups of SWDs, and coupled sub-word lines SWL corresponding to the eight groups of SWDs are sequentially represented as SWL0 and SWL2, SWL4 and SWL6, SWL8 and SWL10, SWL12 and SWL14 is used for description. The first SWD and the second SWD are two SWDs in a same group, and quantities of transistors included in the SWDs in the different groups are consistent with coupling manners between different transistors.

Optionally, the transistor may be a metal-oxide-semiconductor (metal-oxide-semiconductor, MOS) field-effect transistor, referred to as a MOS transistor for short. One electrode of the transistor may be one of a source or a drain, and another electrode of the transistor may be the other of the source or the drain. For example, the first transistor and the third transistor are PMOS transistors, and the second transistor, the fourth transistor, and the fifth transistor are NMOS transistors. In FIG. 4, a first transistor and a third transistor in a first group of two SWDs are represented as TP1 and TP2, and a second transistor, a fourth transistor, and a fifth transistor are represented as TK1, TK2, and TN.

It may be understood that, in actual application, the foregoing transistor may alternatively be another transistor that can implement a same function. This is not specifically limited in embodiments of this application.

In the word line driver, the first SWD and the second SWD in the first group are used as an example. If the first SWD is selected, that is, when MWLB0 is at a low level, FX0 is at a high level, and FXB0 is at a low level, SWL0 is driven to be at a high level via the transistor TP1. If the first SWD is not selected, there are two cases. In a first case, FX0 is not selected (that is, FX0 is at a low level), FXB0 is at a high level, and SWL0 may be pulled down to a low level via the transistor TK1. In a second case, FX0 is selected, and MWLB0 is not selected, that is, FX0 is at a high level, FXB0 is at a low level, and MWLB0 is at a high level. Because FX2 corresponding to the second SWD in the same group is definitely at a low level, and corresponding FXB2 is definitely at a high level, SWL0 may be pulled down to a low level via the transistor TN and the transistor TK2 of the second SWD. In other words, in the solution of this application, at most one of the sub-selection signals of the two SWDs in the same group is at the high level and at least one of the sub-selection signals is at the low level, so that a same logical function can still be implemented based on this feature and by sharing the transistor TN. This reduces a quantity of transistors.

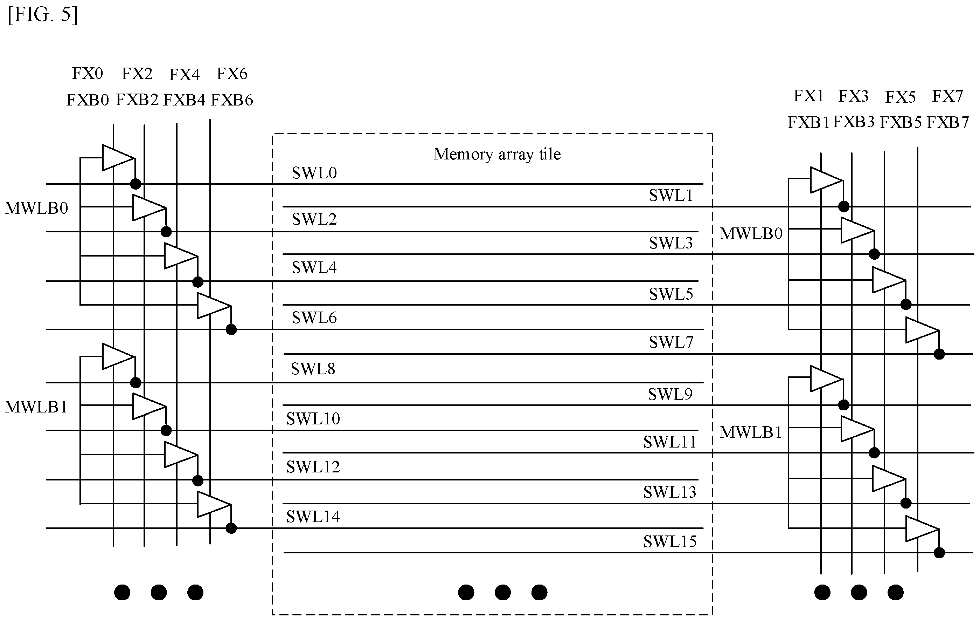

Further, the plurality of word lines in the word line driver may use a hierarchical word line structure. In the structure, the plurality of word lines pass through a plurality of memory array tiles. SWDs on two sides of each memory array tile perform AND logic on selection signals corresponding to the word lines and sub-word lines, thereby forming a driver of the sub-word lines of each memory array tile. For example, as shown in FIG. 5, the plurality of word lines and the plurality of selection lines are disposed in a routing layer (also referred to as a metal layer) on one side of a substrate, the plurality of word lines extend in a first direction parallel to the substrate, the plurality of selection lines extend in a second direction parallel to the substrate, and the first direction is perpendicular to the second direction. In FIG. 5, each word line corresponds to eight sub-word lines in each memory array tile. Selection signals (that is, FX0 to FX7 and FXB0 to FXB7) of eight groups of sub-word lines are used to select a sub-word line, corresponding to a selected word line, in the eight sub-word lines. The eight groups of word lines are represented as SWL0 to SWL15, and the plurality of word lines are represented as MWLB0 and MWLB1. FIG. 5 does not show a specific structure of a plurality of SWDs.

Further, a layout corresponding to the word line driver may include a PMOS region and an NMOS region that are separately disposed. A plurality of PMOS transistors in the plurality of SWDs are disposed in the PMOS region, and a plurality of NMOS transistors in the plurality of SWDs are disposed in the NMOS region.

In a possible embodiment, the PMOS region and the NMOS region include a gate layer, the gate layer may include gates of the plurality of PMOS transistors and gates of the plurality of NMOS transistors, and at least a part of the plurality of word lines are discontinuous in the gate layer, that is, each of the at least a part of word lines is discontinuous at the gate layer. Optionally, each of the at least a part of word lines includes a first word line segment and a second word line segment that are located at the gate layer, the first word line segment and the second word line segment are not connected at the gate layer, and the first word line segment is connected to the second word line segment through at least one routing layer.

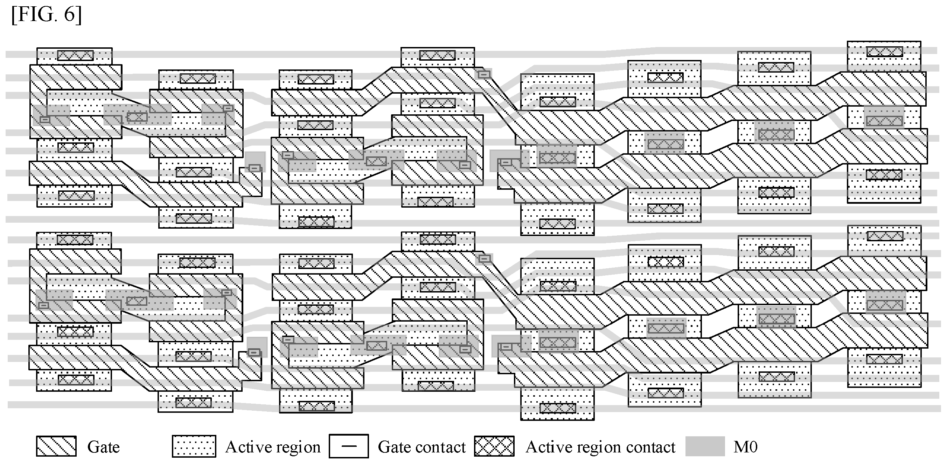

For example, as shown in FIG. 6, a layout includes a PMOS region and an NMOS region, and the PMOS region is located on a right side of the NMOS region. 16 SWDs (that is, corresponding to four groups of MWLB signals and four groups of FX and FXB signals) are disposed in the layout, and a total of 40 transistors are disposed. The PMOS region includes 16 PMOS transistors, and the NMOS region includes 24 NMOS transistors. Gray shown in the figure represents a bottom-most metal layer M0, and is configured to implement routing of SWLs and upward routing of MWLB, FX, and FXB. The metal layer M0 is connected to an active region (active) and a gate (gate) through metal contact (metal contact). In FIG. 6, a plurality of gray routes that pass through horizontally are 16 SWLs, and other square block patterns represent metal pads (pad) that are led out upward from MWLB, FX, and FXB. In this layout, for a plurality of groups of SWDs corresponding to a same MWLB signal, MWLB ports of half of the groups of SWDs are discontinuous at a gate layer, and two separate parts are separately connected to the metal layer M0 through gate contact (gate contact) and then connected to an upper metal layer through a jumper, to connect to the MWLB signal that extends through a higher metal layer. MWLB ports of the other half of the groups of SWDs may be directly connected through a continuous gate metal layer, and are connected to the metal layer M0 through the gate contact and then connected to the upper metal layer through the jumper, to connect to the MWLB signal that extends through the higher metal layer.

In another possible embodiment, the NMOS region includes a first NMOS region and a second NMOS region that are disposed on two sides of the PMOS region, one part of the plurality of NMOS transistors is located in the first NMOS region, and the other part of the plurality of NMOS transistors is located in the second NMOS region. Optionally, the PMOS region, the first NMOS region, and the second NMOS region include the gate layer, and each of the plurality of word lines is continuous in the gate layer, that is, each word line is a complete transmission line at the gate layer.

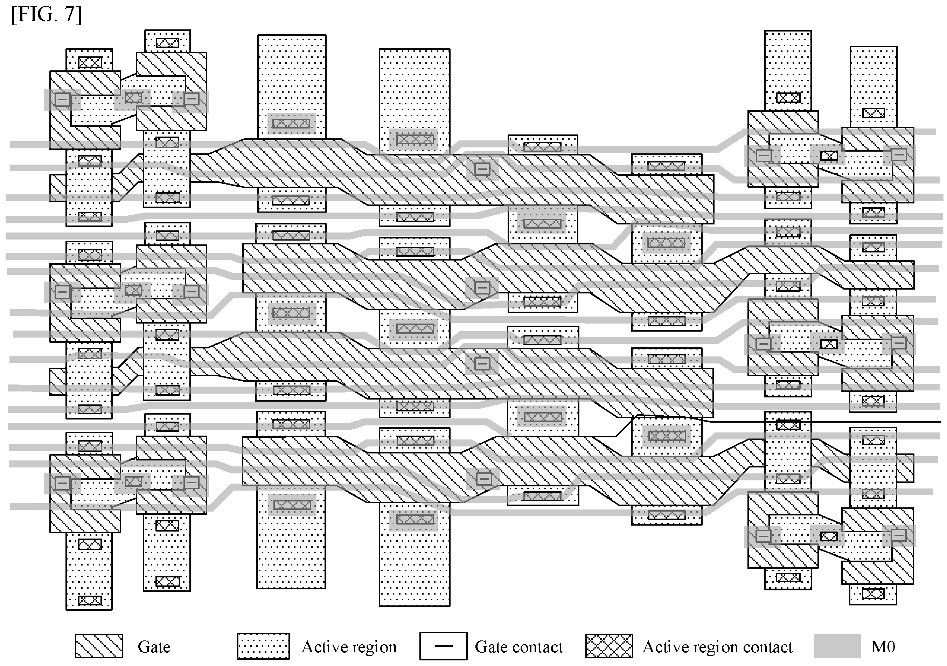

For example, as shown in FIG. 7, a layout includes a PMOS region, and a first NMOS region and a second NMOS region that are disposed on two sides of the PMOS region. 16 SWDs (that is, corresponding to four groups of MWLB signals and four groups of FX and FXB signals) are disposed in the layout, and a total of 40 transistors are disposed. The PMOS region includes 16 PMOS transistors, the first NMOS region includes 12 NMOS transistors, the second NMOS region includes 12 NMOS transistors, and there are 24 NMOS transistors in total (a count 24 herein ignores eight NMOS transistors at the top and the bottom of left and right columns, and the eight NMOS transistors belong to other SWDs that are not drawn in top and bottom extension). Gray shown in the figure represents a bottom-most metal layer M0, and is configured to implement routing of SWLs and upward routing of MWLB, FX, and FXB. The metal layer M0 is connected to an active region (active) and a gate (gate) through metal contact (metal contact). A plurality of gray routes in the figure that pass through horizontally are 16 SWLs, and other square block patterns represent metal pads (pad) used for upward routing from MWLB, FX, and FXB. A difference between this layout and the another layout provided above lies in that the PMOS transistors are located in the middle, and the NMOS transistors are located on the two sides of the PMOS transistor. In addition, for a plurality of groups of SWDs corresponding to a same MWLB signal, MWLB ports of the plurality of groups of SWDs are connected at the gate layer.

In the word line driver provided in this embodiment of this application, each of the first SWD and the second SWD that belong to the same group includes two independent transistors, and the first SWD and the second SWD further share one transistor. In this way, each SWD requires only 2.5 transistors on average. In comparison with a conventional SWD that needs three transistors, an area of the SWD can be reduced, and overall storage density of a memory can be improved. In addition, the gate of the first transistor, the gate of the third transistor, and the gate of the fifth transistor that are in the two SWDs are all coupled to the same word line. In this way, a word line coupled to each sub-word line driver is required to drive only 1.5 transistors on average. In comparison with the conventional SWD in which one word line is coupled to two transistors and therefore needs to drive two transistors, load of word line driving can be reduced, thereby reducing power consumption of a circuit that provides a word line signal. Further, a numbering interval of the first sub-word line and the second sub-word line that correspond to the two SWDs is small. For example, the first sub-word line and the second sub-word line are SWL0 and SWL2, SWL4 and SWL6, or the like. In this way, a minimum pitch (pitch) of a metal routing layer can be reduced while an area of the layout is reduced, and routing difficulty is reduced.

In view of this, an embodiment of this application further provides a memory. The memory includes a memory array tile and a peripheral circuit coupled to the memory array tile. The peripheral circuit may include any word line driver provided above. Further, the peripheral circuit may further include at least one of a row decoder R DEC, a column decoder C DEC, or a sense amplifier SA. For example, a structure of the memory may be described in FIG. 3 above.

Optionally, the memory may include any one of the following: a dynamic random access memory DRAM, a static random access memory SRAM, a magnetic random access memory MRAM, a resistive random access memory ReRAM, a ferroelectric random access memory FeRAM, or a phase change memory PCM.

It may be understood that for detailed descriptions of the memory, refer to the foregoing related descriptions of the word line driver and the memory provided in FIG. 3. That is, content of the foregoing word line driver and the embodiment of the memory provided in FIG. 3 may be referenced to the embodiment of the memory. Details are not described in this embodiment of this application again.

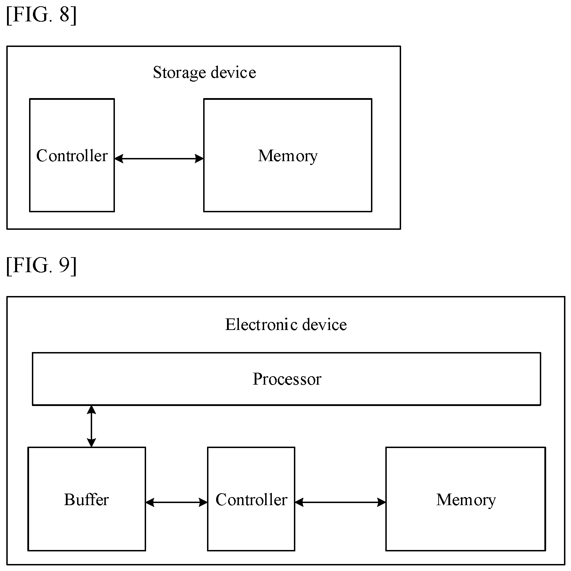

In another aspect of this application, as shown in FIG. 8, a storage device is further provided. The storage device includes a controller and the memory provided above. The controller may be configured to control read/write of the memory.

According to still another aspect of this application, as shown in FIG. 9, an electronic device is further provided. The electronic device includes a processor and a memory that are coupled to each other, and the memory is the memory provided above. Optionally, the processor may include but is not limited to a central processing unit (central processing unit, CPU), a general purpose processor, a graphics processing unit (graphic processing unit, GPU), an image signal processor (image signal processor, ISP), a digital signal processor (digital signal processor, DSP), a network processing unit (network processing unit, NPU), an artificial intelligence (artificial intelligence, AI) processor, a controller, and the like.

Further, the electronic device may further include a buffer and/or a controller. The processor, the buffer, the controller, and the memory may be integrated together or separately disposed. The memory may be coupled to the buffer via the controller, and may be coupled to the processor via the buffer.

In this application, the electronic device may be used as a terminal device or a server. Optionally, the electronic device includes but is not limited to a mobile phone, a tablet computer, a notebook computer, a desktop computer, a palmtop computer, an ultra-mobile personal computer (ultra-mobile personal computer, umPC), a mobile internet device (mobile internet device, MID), a netbook, a video camera, a camera, a wearable device (such as a smart watch or a smart band), a vehicle-mounted device (such as a car, a bicycle, an electric vehicle, an airplane, a ship, a train, or a high-speed railway), a virtual reality (virtual reality, VR) device, an augmented reality (augmented reality, AR) device, a wireless terminal in industrial control (industrial control), a smart home device (such as a refrigerator, a television, an air conditioner, and an electric meter), a smart robot, a workshop device, a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), a flight device (for example, a smart robot, a hot air balloon, an unmanned aerial vehicle, or an airplane), or the like.

It may be understood that related descriptions of the memory and the word line driver provided above may be referenced to the embodiment of the electronic device. Details are not described in this embodiment of this application again.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A word line driver, wherein the word line driver comprises:
a plurality of word lines, comprising a first word line;
a plurality of sub-word lines, comprising a first sub-word line and a second sub-word line; and
a plurality of sub-word line drivers, comprising a first sub-word line driver and a second sub-word line driver, wherein
the first sub-word line driver comprises a first transistor and a second transistor, the second sub-word line driver comprises a third transistor and a fourth transistor, and the first sub-word line driver and the second sub-word line driver further share a fifth transistor; and
a gate of the first transistor, a gate of the third transistor, and a gate of the fifth transistor are all coupled to the first word line, an electrode of the first transistor, an electrode of the second transistor, and an electrode of the fifth transistor are all coupled to the first sub-word line, an electrode of the third transistor, an electrode of the fourth transistor, and another electrode of the fifth transistor are all coupled to the second sub-word line, another electrode of the first transistor and another electrode of the third transistor are respectively configured to receive a first selection signal and a second selection signal, another electrode of the second transistor and another electrode of the fourth transistor are both coupled to a ground end, and a gate of the second transistor and a gate of the fourth transistor are respectively configured to receive an inverted signal of the first selection signal and an inverted signal of the second selection signal.

2. The word line driver according to claim 1, wherein the word line driver further comprises a plurality of selection lines that provide the selection signals and the inverted signals, the plurality of word lines and the plurality of selection lines are disposed in a routing layer on a side of a substrate, the plurality of word lines extend in a first direction parallel to the substrate, the plurality of selection lines extend in a second direction parallel to the substrate, and the first direction is perpendicular to the second direction.

3. The word line driver according to claim 1 or 2, wherein the first transistor and the third transistor are PMOS transistors, and the second transistor, the fourth transistor, and the fifth transistor are NMOS transistors.

4. The word line driver according to claim 3, wherein the word line driver further comprises a PMOS region and an NMOS region that are separately disposed, a plurality of PMOS transistors in the plurality of sub-word line drivers are disposed in the PMOS region, and a plurality of NMOS transistors in the plurality of sub-word line drivers are disposed in the NMOS region.

5. The word line driver according to claim 4, wherein the PMOS region and the NMOS region comprise a gate layer, and at least a part of the plurality of word lines are discontinuous in the gate layer.

6. The word line driver according to claim 5, wherein each of the at least a part of word lines comprises a first word line segment and a second word line segment that are located at the gate layer, and the first word line segment is connected to the second word line segment through at least one routing layer.

7. The word line driver according to claim 4, wherein the NMOS region comprises a first NMOS region and a second NMOS region that are disposed on two sides of the PMOS region, one part of the plurality of NMOS transistors is located in the first NMOS region, and the other part of the plurality of NMOS transistors is located in the second NMOS region.

8. The word line driver according to claim 7, wherein the PMOS region and the NMOS region comprise a gate layer, and each of the plurality of word lines is continuous in the gate layer.

9. A memory, wherein the memory comprises a memory array tile and a peripheral circuit coupled to the memory array tile, and the peripheral circuit comprises the word line driver according to any one of claims 1 to 8.

10. The memory according to claim 9, wherein the memory comprises one of the following: a dynamic random access memory DRAM, a static random access memory SRAM, a magnetic random access memory MRAM, a resistive random access memory ReRAM, a ferroelectric random access memory FeRAM, or a phase change memory PCM.

11. A storage device, wherein the storage device comprises a controller and the memory according to claim 9 or 10, and the controller controls reading and writing of the memory.

12. An electronic device, wherein the electronic device comprises a processor and a memory that are coupled to each other, and the memory is the memory according to claim 9 or 10.
